# EUROPEAN PATENT SPECIFICATION

(11) **EP 0 419 037 B1**
(45) Date of publication and mention of the grant of the patent: **03.02.1993**
(21) Application number: 90309053.8
(22) Date of filing: 17.08.1990
(51) Int. Cl.: H03D 3/00, H03K 9/06

(54) **Detector circuit**
Detektorschaltung
Circuit de détection

(30) Priority: 29.08.1989 US 419570
(43) Date of publication of application: 27.03.1991
(73) Proprietor: DELCO ELECTRONICS CORPORATION, Kokomo Indiana 46902 (US)
(72) Inventor: Kennedy, Richard A., Russinville, Indiana 46979 (US); Zarabadi, Seyed R., Columbus, Ohio 43202 (US)
(74) Representative: Denton, Michael John

(56) References cited:
- US-A- 4 496 858
- PATENT ABSTRACTS OF JAPAN, vol. 7, no. 52 (E-162)[1197], 2nd March 1983 & JP-A-57 203 314
- IEEE TRANSACTIONS ON CIRCUITS AND SYSTEMS, vol. CAS-33, no. 8, August 1986, pages 836-838, New York, US; K. WATANABE et al.: "Switched-capacitor frequency-to-voltage and voltage-to-frequency converters"
- 1987 IEEE INTERNATIONAL SYMPOSIUM ON CIRCUITS AND SYSTEMS, 4th - 7th May 1987, vol. 3, pages 722-725, IEEE, New York, US; G.W. ROBERTS et al.: "SC circuit simulations of state-space formulations derived from LC ladder network prototypes"

## Description

The present invention relates to improvements in or relating to circuits, such as FM detector circuits. A typical prior art circuit is shown in US-A-4,704,545.

Extensive use is made of frequency modulation of carrier signals (FM) in both radio and wire transmission systems as it enables high fidelity substantially noise free information to be transmitted and received. However, this depends upon both the modulation and detection of the transmitted signal being free from internal circuit noise and upon the receipt of a reasonably strong signal at the receiver.

FM detectors can be thought of as being, essentially, frequency to voltage converters. Early FM detector circuits were made up of differentiators, diode detectors and filters. They created an output known as the "S" curve, which would be zero when the Intermediate Frequency (IF) signal was unmodulated and would vary to values above and below zero when the IF signal was modulated. Only the linear portion of the "S" curve can be used for FM reception.

A disadvantage with these early circuits is that the coils and resistors used cannot be reduced for incorporation into integrated circuits.

With the advent of switched capacitor circuits to simulate resistors in integrated circuits, frequency-to-voltage converters in integrated form have been suggested. An example of a frequency-to-voltage converter is described in an article entitled "Switched-Capacitor Frequency-to-Voltage and Voltage-to-Frequency Converters" published in the IEEE TRANSACTIONS ON CIRCUITS AND SYSTEMS VOL 33, NO 6, August 1986. This article suggests that the circuits it discloses are suitable for use in a modem for transmitting or receiving FM signals. However, there is a serious possibility of noise being generated when the circuits are used in an FM detector for receiving standard commercial broadcast signals. The unwanted noise at the output of the detector occurs in the form of beat frequencies of the clock signals generated at the input from received FM signals and from the fixed rate clock signals used in the switched capacitor feedback circuit.

It is desirable to have an FM detector in integrated circuit form which uses switched capacitor circuits that do not generate undesirable noise due to beat frequencies.

A first aspect of the present invention is characterised over the prior art by the features defined in the characterising portion of claim 1.

A second aspect of the present invention is defined in claim 10.

The use of the first switched capacitor circuit as an input to the first amplifier and the use of a second switched capacitor circuit as a feedback element of the second amplifier serves to separate electrically the two switched capacitor circuits. Accordingly, beat frequencies which would be likely to occur if the two circuits were used as an input circuit and as feedback circuit, respectively, of a single amplifier can be eliminated. The use of switched capacitor circuits having similar structures that are fabricated using a common integrated circuit (IC) process results in a cancelling out of process and operating temperature variations.

An embodiment of the present invention is described below, by way of example only, with reference to the accompanying drawings, in which:
Figure 1 shows a schematic diagram of an embodiment of FM detector;
Figure 2 shows graphs of clocking signals used with the FM detector of Figure 1;
Figure 3 shows a graph of detector output voltage against input frequency; and
Figure 4 shows a schematic diagram of a transmission gate used in the FM detector of Figure 1.

For the purposes of illustration only, the parameters of standard US commercial FM broadcast signals will be used, in which the FM carrier signal lies in the frequency range of 87.5 MHz to 108.0 MHz and is modulated so as to vary by plus or minus 75 KHz from its centre frequency. The signal received by the FM receiver is mixed, by means of an FM mixer, with the output of a local tunable oscillator to generate an Intermediate Frequency (IF) signal in known manner. The IF signal has a centre frequency of 450 KHz and is modulated in accordance with the received FM signal so as to vary between plus and minus 75 KHz of the centre frequency.

The term "switched capacitor circuit" is used in the following description to denote a circuit in which equal packets of electrical charge are conveyed from or through a capacitor to a load. In such circuits, it is essential that the capacitor be fully charged and discharged during each switching cycle. A switched capacitor circuit can be thought of as being the equivalent of a resistor connected between a source potential (e.g., a fixed bias potential or a signal source) and a load (e.g., the input of an operational amplifier). It behaves as a discrete time equivalent of a resistor which, of course, is a continuous time device. The effective resistance of the switched capacitor circuit varies inversely as a function of both capacitor size and frequency of switching.

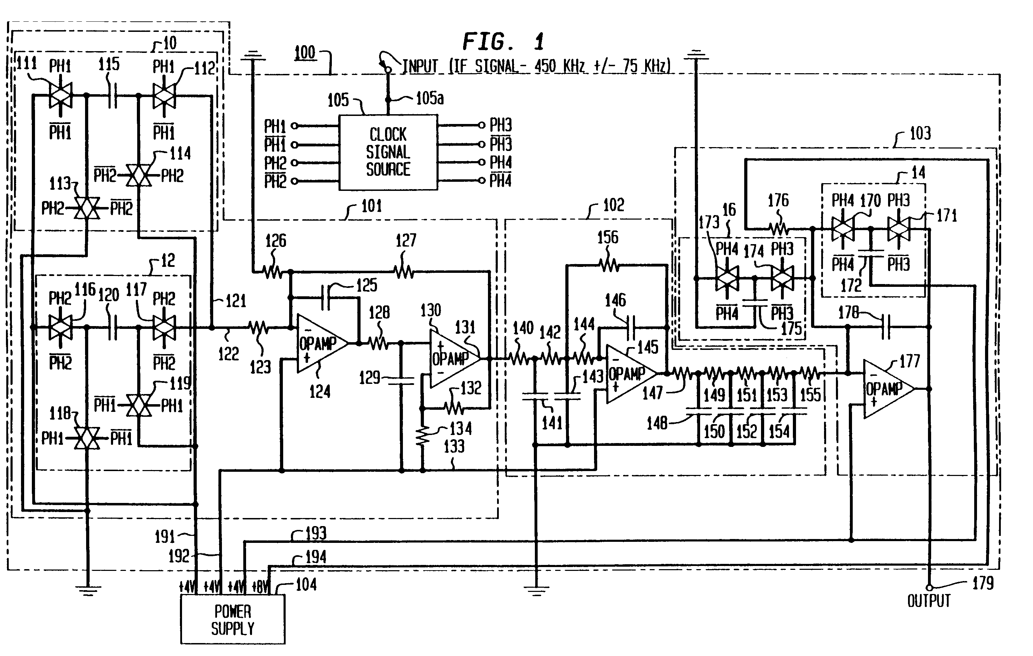

Referring to Figure 1, an FM detector 100 comprises a frequency-to-voltage converter 101, a compensation circuit 103, and a clock signal source 105. A power supply 104 used to power the FM detector 100 has three separate +4 volt outputs which are coupled to conductors 191, 192, and 193 respectively, and has a separate fourth output of +8 volts which is coupled to a conductor 194.

The clock source 105 has an input terminal 105a which serves as an input terminal to the FM detector 100, to which is applied the intermediate frequency (IF) signal.

The clock signal source 105 has a number of pairs of output terminals PH1 and P̅H̅1̅, PH2 and P̅H̅2̅, PH3 and P̅H̅3̅, PH4 and P̅H̅4̅, such that the outputs of each pair of output terminals are complements of each other.

The signals generated at the PH1 and PH2 output terminals are non-overlapping clock signals which correspond to the zero crossings of the IF signal. As is known, information on the IF signal is represented by variations in frequency of that signal, in accordance with variations in the received FM radio signal. Thus, the signals generated at the terminals PH1 and PH2 vary in frequency in accordance with the variations in the received FM signal.

The signals generated at the outputs PH3 and PH4 are non-overlapping clock signals having a fixed oscillating frequency of 3.6 MHz.

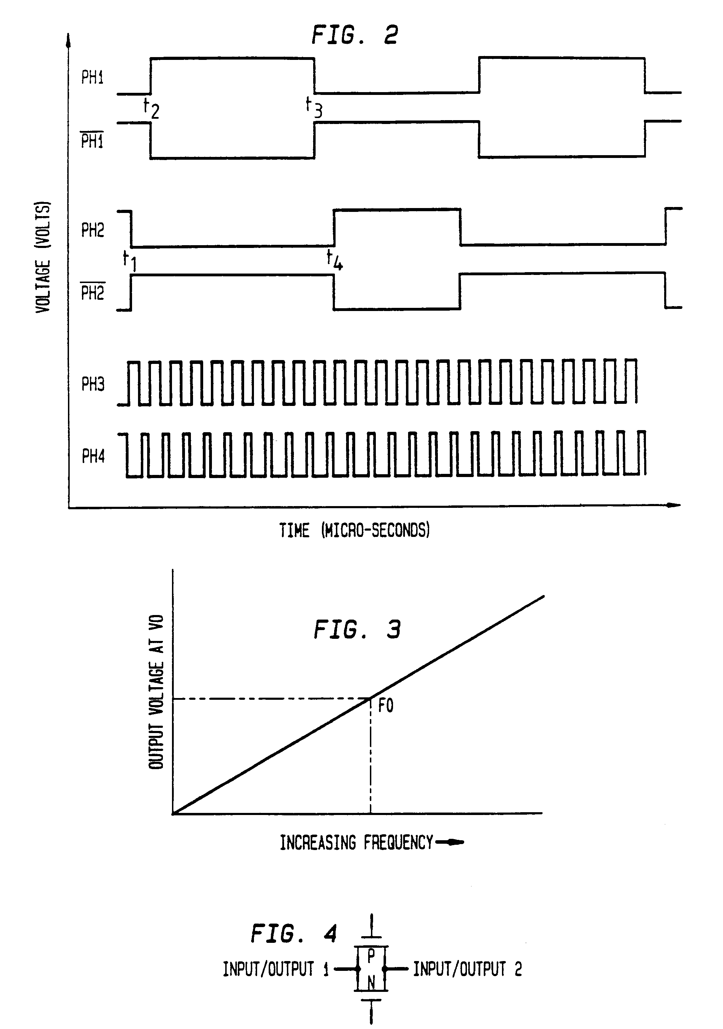

Figure 2 shows the signal waveforms generated by the clock signal source 105 at the outputs PH1, P̅H̅1̅, PH2, P̅H̅2̅, PH3 and PH4. It is to be noted that in the waveforms shown, PH2 is approximately the complement of PH1, differing in that PH2 goes low, at T=t1, before PH1 goes high, at T=t2, and in that it goes high, at T=t4, after PH1 goes low, at T=t3. Thus PH1 and PH2 are denoted as being non-overlapping. PH3 bears the same relationship to PH4 (i.e., they are non-overlapping) as PH1 bears to PH2.

PH1, PH2, PH3 and PH4 and their complements serve as inputs to the FM receiver 100. The receiver 100 has an output terminal 179 at which is generated an output voltage signal.

The frequency-to-voltage converter 101 comprises first and second switched capacitor circuits 10 and 12, an inverting operational amplifier 124, a non-inverting operational amplifier 130, resistors 121, 123, 126, 127, 128, 132 and 134, and capacitors 125 and 129.

The switched capacitor circuit 10 comprises transmission gates 111, 112, 113 and 114 and a capacitor 115. Similarly, the switched capacitor circuit 12 comprises transmission gates 116, 117, 118 and 119 and a capacitor 120.

In the illustrated embodiment, each of the transmission gates 111 to 114, and 116 to 119 comprises an n-channel and a p-channel metal-oxide-semiconductor field effect transistor (MOSFET) coupled together in a parallel configuration to provide a low impedance bilateral transmission path. Figure 4 shows more clearly such a transmission gate. A first common set of terminals of the two transistors, for example the two source terminals, are coupled to a first input/output terminal 1, while a second common set of terminals of the two transistors, for example the two drain terminals, are coupled to a second input/output terminal 2. The transmission gate is operated by applying a first control signal to the gate of the p-channel transistor and the complement (inverse) signal to the gate of the n-channel transistor. For example, in the transmission gate 111 of Figure 1, the output PH1 is applied to the gate terminal of the first transistor (e.g., the gate of the p-channel transistor) and the signal PH1 is applied to the gate terminal of the second transistor (e.g., the gate of the n-channel transistor) in such a manner as to control the conduction of signals through the two input/output terminals 1 and 2.

In the circuit shown, specifically, the first input/output terminals of the transmission gates 111, 114, 116 and 119 are coupled to the conductor 191 which is coupled to the first +4 volt output terminal of the power supply 104. The first input/output terminals of the transmission gates 113 and 118 are coupled to ground, although may be coupled to some other reference voltage. The second input/output terminals of the transmission gates 111 and 113 are coupled to a first terminal of capacitor 115. The second input/output terminal of the transmission gate 114 and the first input/output terminal of the transmission gate 112 are coupled to the second terminal of the capacitor 115. The second input/output terminals of the transmission gates 116 and 118 are coupled to a first terminal of the capacitor 120. The second input/output terminal of the transmission gate 119 is coupled to the first input/output terminal of the transmission gate 117 and to the second terminal of the capacitor 120. The second input/output terminals of the transmission gates 112 and 117 are coupled, via a conductor 121, to a first terminal of the resistor 123. The second terminal of the resistor 123 is coupled to the negative input of the operational amplifier 124, to first terminals of the resistors 126 and 127 and to the first terminal of the capacitor 125. The positive input of the operational amplifier 124 and the first terminals of the capacitor 129 and the resistor 134 are coupled, via the conductor 192, to the second +4 volt output terminal of the power supply 104. The second terminal of the resistor 126 is coupled to ground.

The output of the amplifier 124 is coupled to the second terminal of the capacitor 125 and to a first terminal of the resistor 128. The second terminal of the resistor 128 is coupled to the second terminal of the capacitor 129 and to the positive input of the amplifier 130. The negative input of the amplifier 130 is coupled to a first terminal of the resistor 132 and, to the second terminal of the resistor 134. The output of the amplifier 130 is coupled by means of the conductor 131, to the second terminals of the resistors 127 and 132 and to a first terminal of the resistor 140 of the narrow band-pass filter 102.

With the circuit as shown in Figure 1, the capacitor 115 becomes fully charged between the +4 volts on conductor 191 and ground, when the output PH2 of the clock signal source 105 is high, this causing the gates 113 and 114 to be biased on such that one terminal of the capacitor 115 is effectively connected directly to the first +4 volt terminal of the power supply 104 and the other terminal is connected to ground. Subsequently, when the output PH1 is set high, the left-hand terminal of the capacitor 115 becomes connected to the same 4 volt supply through the conductor 191 by appropriate operation of the gate 111, and at the same time the right-hand terminal of the capacitor 115 becomes connected to the conductors 121 and 122 by appropriate operation of the gate 112. The 4 volt initial charge on the capacitor 115 and the subsequent +4 volt charge on the conductor 191, through the conductors 121 and 122, are additive and produce an 8 volt signal on the conductor 122 which is supplied to the resistor 123, this signal being supplied to the inverting input of the amplifier 124.

In the second switched capacitor circuit 12, the capacitor 120 is charged when the signal at PH1 is high, and discharged when the signal at PH2 is low.

The switched capacitor circuits 10 and 12 operate together at twice the frequency of the IF signal, i.e. at 900 kHz when the IF signal is not modulated. In the illustrated embodiment, when the IF signal is not modulated, the switched capacitor circuits 10 and 12, acting together, appear as a resistor of 277,777 ohms connected between a +8 volt supply and the inverting input of operational amplifier (opamp) 124.

However, when the frequency of the IF signal varies from the 450 kHz centre frequency, the effective resistance of the switched capacitor circuits 10 and 12 will also vary. For example, when the IF signal is at 375 kHz (i.e., 450 kHz minus 75 kHz due to modulation), the two circuits 10 and 12 together appear as a resistor of 333,333 ohms and operate at a frequency of 750 kHz. Similarly, when the IF signal is at 525 kHz, the two circuits 10 and 12 together appear as a resistor of 238,095 ohms and operate at a frequency of 1050 kHz.

It will be apparent that the resistance values are given by way of example and may be different from circuit to circuit because of design, process and temperature variations.

As a consequence of the change in apparent resistance of the two switched capacitor circuits 10 and 12, the voltage at the inverting input of the amplifier 124 will vary in accordance with this change in resistance. Thus, the output of frequency-to-voltage converter 101 will change, also in accordance with this change in resistance, and hence as a function of the change in frequency of the input signals PH1 and PH2, and of the IF signal.

The output voltage VO at the output 179 is dictated by the output of the frequency-to-voltage converter 101 and will only be different therefrom if it is affected by the filter circuit 102 on the compensation circuit 103. Figure 3 shows an idealised curve of how the output voltage VO varies with changes in the input frequency. The point FO denotes the output voltage when there is no information in the IF signal, i.e. when the IF signal is unmodulated. Information in the IF signal causes the output voltage to vary from this base value in the manner shown in Figure 3.

As noted earlier herein, the desired dc output voltage VO at the output terminal 179 for an IF signal without modulation is +4 volts. However, when an IF signal is applied to the inputs of the switched capacitor circuits 10 and 12, an unwanted offset voltage is produced at the output of the amplifier 124 and of the succeeding amplifier stages. The resistor 126 is provided to nullify the effect of this offset voltage, and is connected in series between the two switched capacitor circuits 10 and 12 and ground. It has a value of 277,777 ohms which corresponds to the effective resistance of the switched capacitor circuits 10 and 12 for an IF signal without modulation, so that, under these conditions, the inverting input of the amplifier 124 is at +4 volts.

In the FM detector circuit 100 of Figure 1, filtering is conveniently distributed throughout the circuit. For example, the resistor 128 and the capacitor 129 are part of the distributed filtering.

Since the amplifier 130 is operated as a non-inverting amplifier, its output can provide feedback to the inverting input of the amplifier 124. In Figure 1, the feedback resistor 127 has a value of 208,333 ohms and is arranged such that the gain of the amplifiers 124 and 130 is established by the ratio of the value of the feedback resistor 127 to the resistance of the circuits 10 and 12. However, in the absence of the compensation circuit 103, changes in circuit parameters caused by the manufacturing process and temperature variations in the resistors and capacitors of the frequency-to-voltage converter 101 may seriously alter the operating parameters of the circuit both initially and during its operating life.

The narrow band filter 102 comprises an inverting amplifier 145, a first set of resistors 140, 142, and 144 connected in series and two shunt capacitors 141 and 143, the resistor 144 of the set being coupled to the negative input of the amplifier 145; a second set of resistors 147, 149, 151, 153 and 155 connected in series and to four shunt capacitors 148, 150, 152 and 154, the resistor 147 of the set being coupled to the output of the amplifier 145. The filter 104 further comprises a resistor 156 and a capacitor 146 connected in parallel between the output of the amplifier 145 and its negative input.

More specifically, the second terminal of the resistor 140 is coupled to a first terminal of the resistor 142 and to a first terminal of the capacitor 141. The second terminal of the resistor 142 is coupled to first terminals of the resistors 144 and 156 and of the capacitor 143. The second terminal of the resistor 144 is coupled to the negative input of the amplifier 145 and to a first terminal of the capacitor 146. The output of the amplifier 145 is coupled to the second terminals of the resistor 156 and the capacitor 146 and to a first terminal of the resistor 147. The second terminal of the resistor 147 is coupled to first terminals of the resistor 149 and of the capacitor 148. The second terminal of the resistor 149 is coupled to first terminals of the resistor 151 and the capacitor 150. The second terminal of the resistor 151 is coupled to first terminals of the resistor 153 and of the capacitor 152. The second terminal of the resistor 153 is coupled to first terminals of the resistor 155 and of the capacitor 154. The second terminals of the capacitors 141, 143, 148, 150, 152 and 154 are coupled to ground. The second terminal of the resistor 155 is coupled to the negative input of the operational amplifier 177 of the compensation circuit 103.

The resistors 147, 149, 151, 153, and 155 are constructed so as to be identical to the construction of feedback resistor 127. That is, the resistor 127 is constructed of five equal sections corresponding to the resistors 147-155 and those sections are interconnected by nodes corresponding to the nodes to which the capacitors 148-154 are connected. The total value of the series connected resistors 147-155 is thus 208,333 ohms to match the value of the resistor 127.

Although shown as being part of the filter arrangement 102, the resistors 147-155 also form a resistor for connecting the output of the amplifier 145 to the inverting input of the amplifier 177.

The compensation circuit 103 comprises the operational amplifier 177, third and fourth switched capacitor circuits 14 and 16 and a capacitor 178. The switched capacitor circuit 14 comprises two transmission gates 170 and 171 and a capacitor 172. Similarly, the switched capacitor circuit 16 comprises two transmission gates 173 and 174 and a capacitor 175.

First input/output terminals of the transmission gates 170 and 174 and a first terminal of the resistor 176 are coupled to a first terminal of the capacitor 178 and to the negative input terminal of the amplifier 177. The second terminal of the capacitor 178 is coupled to the output of the amplifier 177, to a first input/output terminal of the transmission gate 171 and to the FM detector output terminal 179. The second input/output terminals of the transmission gates 170 and 171 are coupled to a first terminal of the capacitor 172. The second terminal of the capacitor 172 is coupled to the positive input of the amplifier 177 and, via the conductor 193, to the third +4 volt output terminal of the power supply 104. The second input/output terminal of the transmission gate 174 is coupled to a first input/output terminal of the transmission gate 173 and to a first terminal of the capacitor 175. The second terminal of the capacitor 175 and the second input/output terminal of the transmission gate 173 are connected to ground. The control, gate terminals of the transistors of the transmission gates 171 and 174 are coupled to the outputs PH3 and P̅H̅3̅ of the clock signal source 105, while the control, gate terminals of the transistors of the transmission gates 170 and 173 are coupled to the outputs PH4 and P̅H̅4̅ of the clock signal source 105.

In the compensation circuit 103, feedback is provided through the transmission gates 170 and 171 and the capacitor 172.

When the output PH3 is high, the output potential of the amplifier 177 charges the capacitor 172 to +4 volts through the conductor 193. When the output PH4 is high, the charge on the capacitor 172 is delivered to the inverting input of the amplifier 177 through the gate 170. This circuit, and the switched capacitor circuit 16, will operate at a fixed frequency of 3.6 MHz in accordance with the frequency of the outputs PH3 and PH4. The effective resistance of this feedback circuit is selected to be 277,777 ohms in order to match the resistance of the switched capacitor inputs 10 and 12 when the IF signal is not modulated thereby providing unit gain through the decoder circuit 100 during this state. The value of the capacitor 172 is chosen to be 1 picoFarad.

As will be apparent from the above, the roles of the switched capacitor circuits 10 and 12 and of the feedback resistor 127 of converter 101 are reversed in the compensating circuit 103 by switched capacitors feedback circuits 14 and 16 and resistor 176. Accordingly, variations in circuit parameters due to the manufacturing process and temperature changes produce complementary effects in the converter 101 and in the compensating circuit 103. Furthermore, electrical isolation (separation) of the switched capacitor circuits 10 and 12 of the converter circuit 101 and of switched capacitor feedback circuits 14 and 16 of the compensation circuit 103 helps ensure interference beat frequency signals are not generated.

The gates 173 and 174, like the gates 170 and 171, are operated by the 3.6 MHz clock signals of the outputs PH3 and PH4. Therefore, no beat frequencies are generated during operation of the two switched capacitor circuits 14 and 16 of the compensation circuit 103.

In the converter circuit 101, the switched capacitor circuits 10 and 12 appear as a 277,777 ohm resistor, when the IF signal is unmodulated, having one terminal effectively connected to a +8 volt supply and the other terminal connected to the resistor 126 which is also connected to ground. In the compensation circuit 103, the connections of the switched capacitor circuits 14 and 16 and the resistor 176 are reversed with respect to the +8 volt source of the power supply 104 and ground. These complementary couplings allow close tracking of the voltages applied to the inputs of the amplifiers 124 and 177 over a useful range of variations in circuit parameters due to the manufacturing process, operating temperature and power supply variations of an integrated circuit. The resistors (e.g., 126 and 176) and the capacitors (e.g. 115, 120 and 175) are manufactured to have the same structures such that their values alter together with variations in operating temperature and will behave in the same way to changes in the circuit parameters due to the manufacturing process of the integrated circuit.

The FM detector 100 can be fabricated as an integrated circuit on a single semiconductor (e.g., silicon) substrate using a complementary metal-oxide-semiconductor (CMOS) process or any other IC process.

Various modifications may be made to the above-described embodiment. For example, only one input switched capacitor circuit may be used instead of the two input switched capacitor circuits 10 and 12 shown. Still further, a combination comprising a switched capacitor circuit (such as the switched capacitor circuit 10), an operational amplifier (such as the amplifier 124) and a continuous impedance feedback device (such as the resistor 127) may be used to perform a linear FM detector function (i.e., frequency-to-voltage conversion). In this combination an output of the switched capacitor circuit may be coupled to an inverting input of the operational amplifier and the feedback resistor may be coupled between the inverting input and the output of the amplifier. This combination may be modified so as to include a non-inverting amplifier having an input coupled to the output of the inverting amplifier and having its output coupled to the output of the combination. Furthermore, the frequency-to-voltage converter 101 may be used by itself in some applications. Still further, the components of the above-described combination may be arranged to form a new combination in which the switched capacitor circuit is used as the feedback circuit and the resistor is used as an input circuit with one terminal thereof coupled to the input of the amplifier and a second terminal thereof coupled to a voltage supply. The inputs of the switched capacitor would serve as the inputs of the new combination. Furthermore, the FM detector 100 may be modified such that the switched capacitor circuits 10 and 12 are used as a feedback circuit for the amplifier 124 and the resistor 127 is used as an input circuit coupled by one terminal to the inverting input of the amplifier 124 and coupled by the second terminal to a voltage source. In this modified version of FM detector, the switched capacitor circuit 14 may be used as an input circuit which couples the output of the amplifier 145 to the inverting input of the amplifier 177 and the resistors 147, 149, 151, 153 and 155 (or a single replacement resistor) are used as a feedback circuit coupled between the inverting input and the output of the amplifier 177.

## Claims

1. A circuit comprising a first amplifier (124); a first switched capacitor circuit (10,12) having inputs coupled to a circuit input terminal (105a), for receiving control signals (PH1, PH2) for controlling the operation thereof, an output of the first switched capacitor circuit being coupled to an input of the first amplifier (124); a first continuous time impedance feedback circuit (127,130) coupled between the input and the output of the first amplifier (124); characterised by a second amplifier (177) having an output coupled to a circuit output terminal (179); a gain controlling circuit (102) having a first terminal coupled to the output of the first amplifier (124) and a second terminal coupled to an input of the second amplifier (177), and having an impedance related to the impedance of the first continuous time impedance feedback circuit (10,12); and a second switched capacitor circuit (14,16) coupled between the input and the output of the second amplifier (177) and being adapted to be actuated by signals applied to the inputs thereof.

2. A circuit according to claim 1, wherein the first and second switched capacitor circuits (10,12;14,16) have similar structures and are fabricated using the same process such that differences between the two switched capacitor circuits and in the operation thereof are substantially eliminated.

3. A circuit according to claim 1 or 2, comprising a third, non-inverting amplifier (130) and a fourth, inverting amplifier (145); wherein the output of the first amplifier (124) is coupled to an input of the third amplifier (130), the output of the third amplifier (130) is coupled to the input of the fourth amplifier (145), the output of the fourth amplifier (145) is coupled to the first terminal of the gain controlling circuit (102) such that the gain controlling circuit is coupled to the output of the first amplifier (124); and wherein the continuous time impedance feedback circuit (127,130) comprises a feedback resistor (127).

4. A circuit according to any one of claims 1 to 3, wherein the gain controlling circuit (102) comprises a first plurality of serially coupled, substantially equal value resistors (147-155) and a first plurality of capacitors (148-154), each capacitor of the first plurality of capacitors being coupled to a common terminal between adjacent resistors of the first plurality of resistors.

5. A circuit according to claim 4, wherein the first switched capacitor circuit (10,12) is connected to a first voltage terminal (191); the circuit comprising a first resistor (126) having a first terminal coupled to the input of the first amplifier (124) and a second terminal coupled to a second voltage terminal; a second resistor (176) having a first terminal coupled to the input terminal of the second amplifier (177) and a second terminal coupled to a third voltage terminal (194); and a third switched capacitor circuit (16) having a first terminal coupled to the input of the second amplifier (177) and a second terminal coupled to the second voltage terminal.

6. A circuit according to claim 5, comprising a fourth switched capacitor circuit (12) having inputs coupled to a circuit input terminal (105a) for receiving control signals (PH1,PH2) for controlling the operation thereof, an output coupled to the input of the first amplifier (124) and a terminal coupled to the first voltage terminal (191).

7. A circuit according to claim 6, wherein the gain controlling circuit comprises a resistor-capacitor network (140-144) coupling the output of the third amplifier (130) to the input of the fourth amplifier (145) to form a frequency filter.

8. A circuit according to claims 5, 6 or 7, wherein the continuous time impedance feedback circuit (127,130) is connected to the second voltage terminal.

9. A circuit according to any preceding claim, wherein the impedance of the gain controlling circuit (102) is substantially the same as the impedance of the continuous time impedance feedback circuit.

10. An FM signal detector circuit comprising:
a frequency to voltage converter (101), which converter includes a first operational amplifier (124), a first switched capacitor circuit (10,12) having an input connected to a first potential source (191) and being actuated in depedence upon a received FM signal, and a feedback resistor (127) connected between the output and a first input of the first amplifier (124); and
a compensation circuit (102,103) including a second operational amplifier (177), an input resistor (147-155) connected between the output of the first amplifier and a first input of the second amplifier, the resistances of the feedback resistor (127) and the input resistor (147-155) having a predetermined relationship to one another, and a second switched capacitor circuit (14) connected between the output and the first input of the second amplifier and being adapted to be actuated at a predetermined frequency; coupling means (140-144) being provided for coupling the output of the first amplifier to the first input of the second amplifier.

11. An FM signal detector according to claim 10, wherein the coupling means (102) comprises a filter (140-144).

12. An FM signal detector according to claim 10 or 11, comprising an offset compensation resistor (126) connected between a second potential source and the first input of the first amplifier (124); and offset compensating means (176) connected to the first input of the second amplifier (177) to compensate for voltage offsets.

13. An FM signal detector according to claim 12, wherein the offset compensating means (176) comprises a compensating resistor (176) connected between a third potential source and the first input of the second amplifier (177); and a third switched capacitor circuit (16) actuated at the predetermined frequency and connected between the second potential source and the first input of the second amplifier (177).

14. An FM signal detector according to claim 13, wherein the first potential source is a mid-supply voltage source, the second potential source is a low voltage source; and the third potential source is a full supply voltage source.

15. An FM signal detector according to claim 14, wherein the first potential source is at 4 volts, the second potential source is at ground; and the third potential source is at 8 volts.

16. An FM signal detector according to any one of claims 10 to 15, wherein the first inputs of the first and second amplifiers (124,177) are inverting inputs.

17. An FM signal detector according to any one claims 10 to 16, wherein the feedback resistor (127) and the input resistor (147-155) have substantially identical structures.

## Patentansprüche

1. Eine Schaltung, welche umfaßt einen ersten Verstärker (124); einen ersten geschalteten Kondensatorkreis (10, 12) mit Eingängen, die mit einer Schaltungs-Eingangsklemme (105a) gekoppelt sind zum Empfangen von Steuersignalen (PH1, PH2) zum Steuern seines Betriebs, wobei ein Ausgang des ersten geschalteten Kondensatorkreises mit einem Eingang des ersten Verstärkers (124) gekoppelt ist; einer ersten kontinuierlichen Zeitimpedanz-Rückkoppelschaltung (127, 130), die zwischen dem Eingang und dem Ausgang des ersten Verstärkers (124) gekoppelt ist; gekennzeichnet durch einen zweiten Verstärker (177) mit einem mit einer Schaltungs-Ausgangsklemme (179) gekoppelten Ausgang; eine Verstärkungsfaktor-Steuerschaltung (102) mit einer ersten mit dem Ausgang des ersten Verstärkers (124) gekoppelten Klemme und einer zweiten mit einem Eingang des zweiten Verstärkers (177) gekoppelten Klemme, die eine auf die Impedanz der ersten kontinuierlichen Zeitimpedanz-Rückkoppelschaltung (10, 12) bezogene Impedanz besitzt; und einen zweiten geschalteten Kondensatorkreis (14, 16), der zwischen dem Eingang und dem Ausgang des zweiten Verstärkers (177) gekoppelt und dazu ausgelegt ist, durch an den Eingängen desselben angelegte Signale betätigt zu werden.

2. Schaltung nach Anspruch 1, bei der der erste und der zweite geschaltete Kondensatorkreis (10, 12; 14, 16) gleichartige Strukturen besitzen und unter Benutzung des gleichen Vorgangs hergestellt sind, so daß Unterschiede zwischen den beiden geschalteten Kondensatorkreisen und dem Betrieb derselben im wesentlichen beseitigt sind.

3. Schaltung nach Anspruch 1 oder 2, welche umfaßt einen dritten nicht-invertierenden Verstärker (130) und einen vierten invertierenden Verstärker (145); wobei der Ausgang des ersten Verstärkers (124) mit einem Eingang des dritten Verstärkers (130) gekoppelt ist, der Ausgang des dritten Verstärkers (130) mit dem Eingang des vierten Verstärkers (145) gekoppelt ist, der Ausgang des vierten Verstärkers (145) mit der ersten Klemme der Verstärkungsfaktor-Steuerschaltung (102) gekoppelt ist, so daß die Verstärkungsfaktor-Steuerschaltung mit dem Ausgang des ersten Verstärkers (124) gekoppelt ist; und wobei die kontinuierliche Zeitimpedanz-Rückkoppelschaltung (127, 130) einen Rückkoppel-Widerstand (127) umfaßt.

4. Schaltung nach einem der Ansprüche 1 bis 3, bei der die Verstärkungsfaktor-Steuerschaltung (102) umfaßt eine erste Vielzahl von in Reihe gekoppelten Widerständen (147-155) von im wesentlichen gleichem Wert und eine erste Vielzahl von Kondensatoren (148-154), wobei jeder Kondensator der ersten Vielzahl von Kondensatoren mit einer gemeinsamen Klemme zwischen benachbarten Widerständen der ersten Vielzahl von Widerständen gekoppelt ist.

5. Schaltung nach Anspruch 4, bei der der erste geschaltete Kondensatorkreis (10, 12) an eine erste Spannungsklemme (191) angeschlossen ist; die Schaltung umfaßt einen ersten Widerstand (126) mit einer mit dem Eingang des ersten Verstärkers (125) gekoppelten ersten Klemme und einer mit einer zweiten Spannungsklemme gekoppelten sweiten Klemme; einen zweiten Widerstand (176) mit einer ersten mit der Eingangsklemme des zweiten Verstärkers (177) gekoppelten Klemme und einer mit einer dritten Spannungsklemme (194) gekoppelten zweiten Klemme; und einen dritten geschalteten Kondensatorkreis (16) mit einer ersten, mit dem Eingang des zweiten Verstärkers (177) gekoppelten Klemme und einer zweiten, mit der zweiten Spannungsklemme gekoppelten Klemme.

6. Schaltung nach Anspruch 5, welche umfaßt einen vierten geschalteten Kondensatorkreis (12) mit Eingängen, die mit einer Schaltung-Eingangsklemme (105a) zum Aufnehmen von Steuersignalen (PH1, PH2) zum Steuern des Betriebs desselben gekoppelt sind, einem mit dem Eingang des ersten Verstärkers (124) gekoppelten Ausgang und einer mit der ersten Spannungsklemme (191) gekoppelten Klemme.

7. Schaltung nach Anspruch 6, bei der eine Verstärkungsfaktor-Steuerschaltung umfaßt ein Widerstands/Kondensator-Netzwerk (140-144), das den Ausgang des dritten Verstärkers (130) mit dem Eingang des vierten Verstärkers (145) zur Bildung eines Frequenzfilters koppelt.

8. Schaltung nach Anspruch 5, 6 oder 7, bei der die kontinuierliche Zeitimpedanz-Rückkoppelschaltung (127, 130) an der zweiten Spannungsklemme angeschlossen ist.

9. Schaltung nach einem der vorangehenden Ansprüche, bei der die Impedanz der Verstärkungsfaktor-Steuerschaltung (102) im wesentlichen die gleiche wie die Impedanz der kontinuierlichen Zeitimpedanz-Rückkoppelschaltung ist.

10. FM-Signaldetektor-Schaltung, welche umfaßt:
einen Frequenz/Spannungs-Wandler (101), welcher Wandler enthält einen ersten Operationsverstärker (124), einen ersten geschalteten Kondensatorkreis (10, 12) mit einem mit einer ersten Spannungsklemme (191) verbundenen Eingang, der in Abhängigkeit von einem empfangenen FM-Signal betätigt wird, und einem zwischen dem Ausgang und einem ersten Eingang des ersten Verstärkers (124) angeschlossenen Rückkoppelwiderstand (127); und
eine Kompensations-Schaltung (102, 103), die enthält einen zweiten Operationsverstärker (177), einen zwischen dem Ausgang des ersten Verstärkers und einem ersten Eingang des zweiten Verstärkers angeschlossenen Eingangs-Widerstand (147-155), wobei die Widerstandswerte des Rückkoppel-Widerstandes (127) und des Eingangs-Widerstandes (147-155) eine vorbestimmte Beziehung zueinander besitzen, und einen zweiten geschalteten Kondensatorkreis (14), der zwischen dem Ausgang und dem ersten Eingang des zweiten Verstärkers angeschlossen und ausgelegt ist, mit einer vorbestimmten Frequenz betätigt zu werden; wobei Kopplungsmittel (140-144) vorgesehen sind, um den Ausgang des ersten Verstärkers mit dem ersten Eingang des zweiten Verstärkers zu koppeln.

11. FM-Signaldetektor nach Anspruch 10, bei dem das Kopplungsmittel (102) ein Filter (140-144) umfaßt.

12. FM-Signaldetektor nach Anspruch 10 oder 11, der umfaßt einen Versatz-Kompensations-Widerstand (126), der zwischen einer zweiten Potentialquelle und dem ersten Eingang des ersten Verstärkers (124) angeschlossen ist; und Versatz-Kompensations-Mittel (176), die an dem ersten Eingang des zweiten Verstärkers (177) angeschlossen sind, um Spannungsversätze auszugleichen.

13. FM-Signaldetektor nach Anspruch 12, bei dem das Versatz-Kompensations-Mittel (176) umfaßt einen Kompensations-Widerstand (176), der zwischen einer dritten Potentialquelle und dem ersten Eingang des zweiten Verstärkers (177) angeschlossen ist; und einen dritten geschalteten Kondensatorkreis (16), der mit der vorbestimmten Frequenz beaufschlagt und zwischen der zweiten Potentialquelle und dem ersten Eingang des zweiten Verstärkers (177) angeschlossen ist.

14. FM-Signaldetektor nach Anspruch 13, bei dem die erste Potentialquelle eine Mittelversorgungsspannung-Quelle ist, die zweite Potentialquelle eine Niederspannungsquelle und die dritte Potentialquelle eine Voll-Versorgungsspannungsquelle ist.

15. FM-Signaldetektor nach Anspruch 14, bei dem die erste Potentialquelle bei 4 V liegt, die zweite Potentialquelle bei Erde und die dritte Potentialquelle bei 8 V.

16. FM-Signaldetektor nach einem der Ansprüche 10 bis 15, bei dem die ersten Eingänge des ersten und des zweiten Verstärkers (124, 177) invertierende Eingänge sind.

17. FM-Signaldetektor nach einem der Ansprüche 10 bis 16, bei dem der Rückkoppel-Widerstand (127) und der Eingangswiderstand (147-155) im wesentlichen identische Strukturen besitzen.

## Revendications

1. Circuit comprenant un premier amplificateur (124); un premier circuit à capacités commutées (10, 12) ayant des entrées reliées à une borne (105a) d'entrée de circuit, pour recevoir des signaux de commande (PH1, PH2) pour commander le fonctionnement de celui-ci, une sortie du premier circuit à capacités commutées étant reliée à une entrée du premier amplificateur (124); un premier circuit à réaction à impédance temporelle continue (127, 130) relié entre l'entrée et la sortie du premier amplificateur (124); caractérisé par un deuxième amplificateur (177) ayant une sortie reliée à une borne (179) de sortie de circuit; un circuit de commande de gain (102) ayant une première borne reliée à la sortie du premier amplificateur (124) et une deuxième borne reliée à une entrée du deuxième amplificateur (177), et ayant une impédance liée à l'impédance du premier circuit (127, 130) à réaction à impédance temporelle continue; et un deuxième circuit à capacités commutées (14, 16) relié entre l'entrée et la sortie du deuxième amplificateur (177) et étant adapté pour être commandé par des signaux appliqués aux entrées de celui-ci.

2. Circuit suivant la revendication 1, dans lequel les premier et deuxième circuits à capacités commutées (10, 12; 14, 16) ont des structures similaires et sont fabriqués en utilisant le même procédé de sorte que les différences entre les deux circuit à capacités commutées et dans le fonctionnement de ceux-ci sont pratiquement éliminées.

3. Circuit suivant la revendication 1 ou 2, comprenant un troisième amplificateur non-inverseur (130) et un quatrième amplificateur inverseur (145); dans lequel la sortie du premier amplificateur (124) est reliée à une entrée du troisième amplificateur (130), la sortie du troisième amplificateur (130) est reliée à l'entrée du quatrième amplificateur (145), la sortie du quatrième amplificateur (145) est reliée à la première borne du circuit de commande de gain (102) de telle manière que le circuit de commande de gain est relié à la sortie du premier amplificateur (124); et dans lequel le circuit à réaction à impédance temporelle continue (127, 130) comprend une résistance de réaction (127).

4. Circuit suivant l'une quelconque des revendications 1 à 3, dans lequel le circuit de commande de gain (102) comprend une première pluralité de résistances (147 - 155) de valeur pratiquement égale reliées en série et une première pluralité de condensateurs (148 - 154), chaque condensateur de la première pluralité de condensateurs étant relié à une borne commune entre des résistances adjacentes de la première pluralité de résistances.

5. Circuit suivant la revendication 4, dans lequel le premier circuit à capacités commutées (10, 12) est relié à une première borne de tension (191); le circuit comprenant une première résistance (126) ayant une première borne reliée à l'entrée du premier amplificateur (124) et une deuxième borne reliée à une deuxième borne de tension; une deuxième résistance (176) ayant une première borne reliée à la borne d'entrée du deuxième amplificateur (177) et une deuxième borne reliée à une troisième borne de tension (194); et un troisième circuit à capacités commutées (16) ayant une première borne reliée à l'entrée du deuxième amplificateur (177) et une deuxième borne reliée à la deuxième borne de tension.

6. Circuit suivant la revendication 5, comprenant un quatrième circuit à capacités commutées (12) ayant des entrées reliées à une borne d'entrée de circuit (105a) pour recevoir des signaux de commande (PH1, PH2) pour commander le fonctionnement de celui-ci, une sortie reliée à l'entrée du premier amplificateur (124) et une borne reliée à la première borne de tension (191).

7. Circuit suivant la revendication 6, dans lequel le circuit de commande de gain comprend un réseau à résistances-condensateurs (140 -144) reliant la sortie du troisième amplificateur (130) à l'entrée du quatrième amplificateur (145) pour former un filtre de fréquences.

8. Circuit suivant les revendications 5, 6 ou 7, dans lequel le circuit à réaction à impédance temporelle continue (127, 130) est relié à la deuxième borne de tension.

9. Circuit suivant l'une quelconque des revendications précédentes, dans lequel l'impédance du circuit de commande de gain (102) est pratiquement la même que l'impédance du circuit à réaction à impédance temporelle continue.

10. Détecteur de signal FM comprenant:
un convertisseur fréquence/tension (101), lequel convertisseur comprend un premier amplificateur opérationnel (124), un premier circuit à capacités commutées (10, 12) ayant une entrée reliée à une première source de potentiel (191) et étant commandé en fonction d'un signal de FM reçu, et une résistance de réaction (127) connectée entre la sortie et une première entrée du premier amplificateur (124); et
un circuit de compensation (102, 103) comprenant un deuxième amplificateur opérationnel (177), une résistance d'entrée (147 - 155) connectée entre la sortie du premier amplificateur et une première entrée du deuxième amplificateur, les valeurs de résistance de la résistance de réaction (127) et de la résistance d'entrée (147 - 155) ayant une relation prédéterminée l'une avec l'autre, et un deuxième circuit à capacités commutées (14) connecté entre la sortie et la première entrée du deuxième amplificateur et étant adapté pour être commandé à une fréquence prédéterminée; des moyens de couplage (140 - 144) étant prévus pour relier la sortie du premier amplificateur à la première entrée du deuxième amplificateur.

11. Détecteur de signal FM suivant la revendication 10, dans lequel les moyens de couplage (102) comprennent un filtre (140 - 144).

12. Détecteur de signal FM suivant la revendication 10 ou 11, comprenant une résistance de compensation de décalage (126) connectée entre une deuxième source de potentiel et la première entrée du premier amplificateur (124); et des moyens de compensation de décalage (176) reliés à la première entrée du deuxième amplificateur (177) pour compenser les tensions de décalage.

13. Détecteur de signal FM suivant la revendication 12, dans lequel les moyens de compensation de décalage (176) comprennent une résistance de compensation (176) connectée entre une troisième source de potentiel et la première entrée du deuxième amplificateur (177); et un troisième circuit à capacités commutées (16) commandé à la fréquence prédéterminée et connecté entre la deuxième source de potentiel et la première entrée du deuxième amplificateur (177).

14. Détecteur de signal FM suivant la revendication 13, dans lequel la première source de potentiel est une source de tension d'alimentation intermédiaire, la deuxième source de potentiel est une source de tension faible; et la troisième source de potentiel est une source de tension totale d'alimentation.

15. Détecteur de signal FM suivant la revendication 14, dans lequel la première source de potentiel est à 4 volts, la deuxième source de potentiel est à la masse; et la troisième source de potentiel est à 8 volts.

16. Détecteur de signal FM suivant l'une quelconque des revendications 10 à 15, dans lequel les premières entrées des premier et deuxième amplificateurs (124, 177) sont des entrées inverseuses.

17. Détecteur de signal FM suivant l'une quelconque des revendications 10 à 16, dans lequel la résistance de réaction (127) et la résistance d'entrée (147 - 155) ont pratiquement des structures identiques.
